# EUROPÄISCHE PATENTSCHRIFT

(11) **EP 0 482 418 B1**
(45) Veröffentlichungstag und Bekanntmachung des Hinweises auf die Patenterteilung: **11.01.1995**
(21) Anmeldenummer: 91117116.3
(22) Anmeldetag: 08.10.1991
(51) Int. Cl.: H05K 7/14

(54) **Ein- und/oder Ausgabegerät für Prozessdaten**
In- and/or output device for processdata
Dispositif d'entrée ou/et sortie pour des données de processus

(30) Priorität: 24.10.1990 CH 3399/90
(43) Veröffentlichungstag der Anmeldung: 29.04.1992
(73) Patentinhaber: ASEA BROWN BOVERI AG, 5400 Baden (CH)
(72) Erfinder: Gasser, Markus, CH-5242 Unterehrendingen (CH); Hänsli, Markus, CH-4658 Däniken (CH); Schneeberger, Stefan, CH-3612 Steffisburg (CH)

(56) Entgegenhaltungen:
- EP-A- 0 165 434
- EP-A- 0 323 579
- DE-U- 8 910 111
- US-A- 4 151 580

## Beschreibung

### TECHNISCHES GEBIET

Bei der Erfindung wird ausgegangen von einem Ein- und/oder Ausgabegerät gemäss dem Oberbegriff von Patentanspruch 1. Solche Ein- und/oder Ausgabegeräte weisen an einem Baugruppenträger befestigte und über Prozessstecker sowie Kabel an eine Vorrichtung zur Durchführung eines Prozesses geführte Baugruppen auf, welche untereinander über einen Systembus kommunizieren. Die Baugruppen enthalten jeweils mindestens eine in einem Gehäuse angeordnete Leiterplatte und nehmen Signale von Signalgebern der Prozessdurchführungsvorrichtung auf, verarbeiten die Signale, gegebenenfalls unter Berücksichtigung von Signalen, die von anderen Baugruppen abgegeben werden, und/oder führen Signale Signalaufnahmen der Prozessdurchführungsvorrichtung zu. Je nach Anforderung kann eine Baugruppe Eingabe-, Ausgabe-, Ein- und Ausgabe- und/oder Verarbeitungsfunktion erfüllen.

### STAND DER TECHNIK

Ein Ein- und/oder Ausgabegerät nach dem dem Oberbegriff von Patentanspruch 1 ist beispielsweise aus EP-A-165434 bekannt. Bei diesem Gerät sind die Prozessstecker jeweils mit einem Schwenkgelenk versehen, welches einer mit der Leiterplatte mechanisch und elektrisch fest verbundenen Steckerleiste angepasst ist. Hierdurch werden durch Bedienung, Verdrahtung und/oder Vibrationen hervorgerufene und auf die frontseitig angeordneten Prozessstecker wirkende Kräfte von jedem Prozessstecker über die Steckerleiste auf die damit fest verbundene Leiterplatte übertragen, welche ihrerseits die Kräfte über das Gehäuse an einen die Baugruppe fixierenden Baugruppenträger abgibt.

### DARSTELLUNG DER ERFINDUNG

Die Erfindung, wie sie im Patentanspruch 1 definiert ist, löst die Aufgabe, ein Ein- und/oder Ausgabegerät der eingangs genannten Art zu schaffen, welches einfach und zweckmässig gestaltet ist und bei dem die Leiterplatte nahezu vollständig vor grossen mechanischen Anforderungen verschont bleibt.

Das Ein- und/oder Ausgabegerät nach der Erfindung zeichnet sich dadurch aus, dass die von den Prozesssteckern in die Baugruppen eingeleiteten Kräfte nahezu vollständig durch mechanisch angepasste Bauteile, wie Steckerleiste und Gehäuse, auf den Baugruppenträger übertragen werden. Dadurch werden die Leiterplatten mechanisch entlastet und können anspruchsvolle elektrische Aufgaben störungsfrei lösen.

### WEG ZUR AUSFÜHRUNG DER ERFINDUNG

Die Erfindung wird nachfolgend anhand von Zeichnungen näher erläutert. Hierbei zeigt:
- Fig. 1: eine perspektivische Ansicht einer vereinfacht dargestellten Ausführungsform des Ein- und/oder Ausgabegerätes nach der Erfindung.
- Fig. 2: eine perspektivische Ansicht der wesentlichen Bestandteile einer Baugruppe des Ein- und/oder Ausgabegerätes nach Fig.1
- Fig. 3: eine Seitenansicht einer Baugruppe des Ein- und/oder Ausgabegerätes nach Fig.1, bei welcher Teile des Baugruppen-Gehäuses entfernt worden sind, und
- Fig.4: eine Aufsicht auf einen längs IV-IV geführten Schnitt durch eine Baugruppe nach Fig.3.

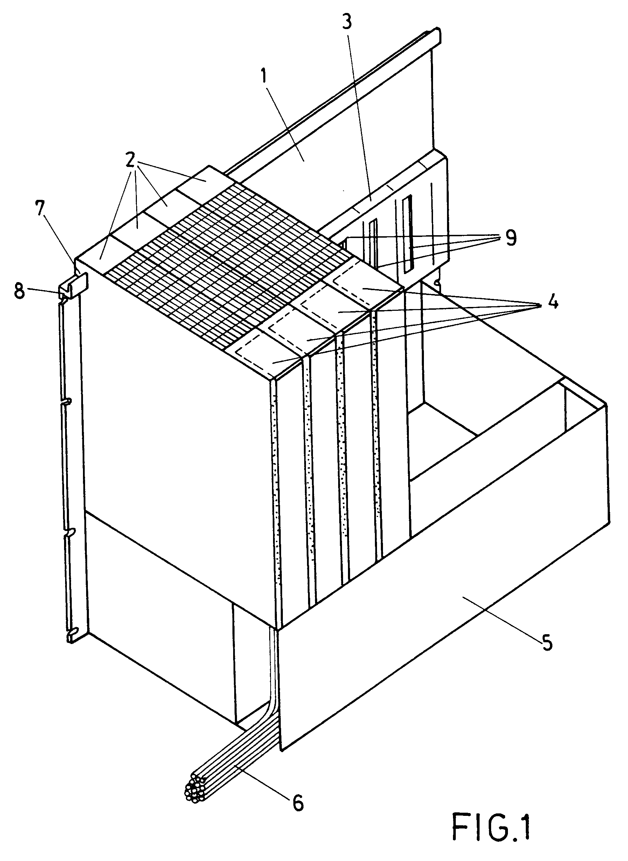

Das in Fig.1 dargestellte Ein- und/oder Ausgabegerät besteht aus nebeneinander auf einen Baugruppenträger 1 montierten, im wesentlichen kastenförmigen Baugruppen 2, von denen aus Gründen der Einfachheit lediglich nur gleichartig aus-gebildete dargestellt sind, dem Baugruppenträger 1 mit einem Bushalter 3 und Prozesssteckern 4. Die Prozessstecker 4 können von den Baugruppen 2 abgekuppelt werden und sind über in einem Kanal 5 geführte Kabel 6 mit nicht dargestellten Signalquellen und Signalaufnahmen einer ebenfalls nicht dargestellten Vorrichtung zur Durchführung eines Prozesses, beispielsweise eines Herstell- oder eines Bearbeitungsverfahrens verbunden. Auf der Rückseite der Baugruppen 2 befinden sich im oberen Teil jeweils eine Befestigungskralle 7 sowie ein aus Fig.1 nicht ersichtlicher Busstecker. Die Befestigungskralle 7 greift in eine am Baugruppenträger 1 angebrachte Halterung 8 ein. Bei der Montage wird jede Baugruppe 2 mit ihrer Befestigungskralle 7 in die Profilschiene 8 eingelegt, mit ihrer Rückseite an den Baugruppenträger 1 geschwenkt und anschliessend durch eine nicht ersichtliche Verschraubung vollständig fixiert. Beim Schwenken bilden der Busstecker und eine am Bushalter 3 vorgesehene Buskupplung 9 eine Steckverbindung, über welche Signale in den vom Bushalter 3 getragenen Bus und damit zu anderen Baugruppen 2 geführt werden und/oder aus dem Bus 3 und damit aus anderen Baugruppen 2 entnommen werden können.

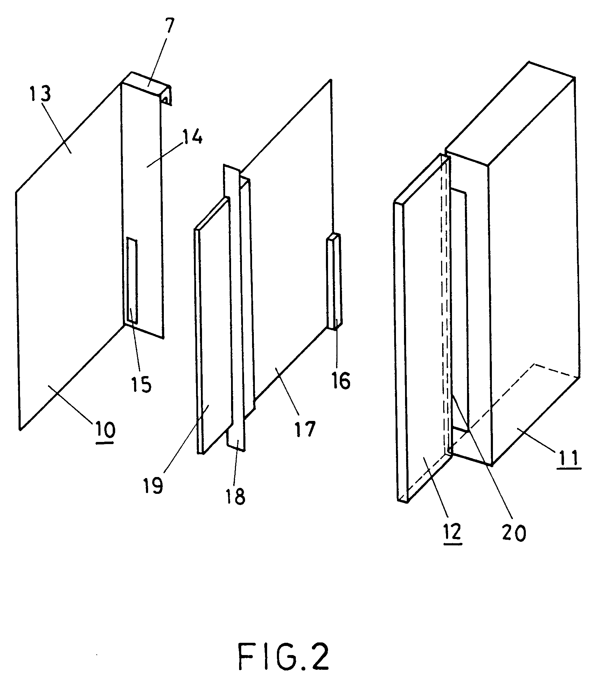

Jede Baugruppe enthält gemäss Fig.2 ein aus einem Tragteil 10 sowie Abdeckungen 11, 12 gebildetes Gehäuse. Das Tragteil 10 ist im wesentlichen von zwei zueinander L-förmig angeordneten Platten gebildet, von denen die eine als Seitenwand 13 und die andere als Rückwand 14 des Gehäuses der Baugruppe 2 verwendet wird. In der im oberen Teil die Befestigungskralle tragenden, gegebenenfalls aber auch Oeffnungen zum Anbringen der Befestigungskralle enthaltenden, Rückwand 14 ist eine Oeffnung 15 vorgesehen, welche der Durchführung eines Bussteckers 16 dient. Der Busstecker 16 ist auf dem Tragteil 10 lagerbar und weist mit nicht dargestellten Leiterbahnen einer Leiterplatte 17 kontaktierte und ebenfalls nicht dargestellte Anschlussstifte auf. Die Leiterplatte 17 ist mit einer auf dem Tragteil 10 abstützbaren Steckerleiste 18 mit Anschlussstiften, welche mit Anschlussbuchsen des Prozessteckers 4 zusammenwirken, sowie mit mindestens einer nicht dargestellte Anzeigedioden tragenden Leiterplatte 19 verbunden. Beim Zusammenbau der Baugruppe 2 wird die Steckerleiste 18 auf dem Tragteil 10 fixiert und werden die damit verbundenen Leiterplatten 17 und 19 durch Aufschnappen der Abdeckungen 11 und 12 in das hierbei gebildete Gehäuse eingeschlossen. Eine in der Abdeckung 11 vorgesehene Oeffnung 20 dient der Durchführung der Steckerleiste 18.

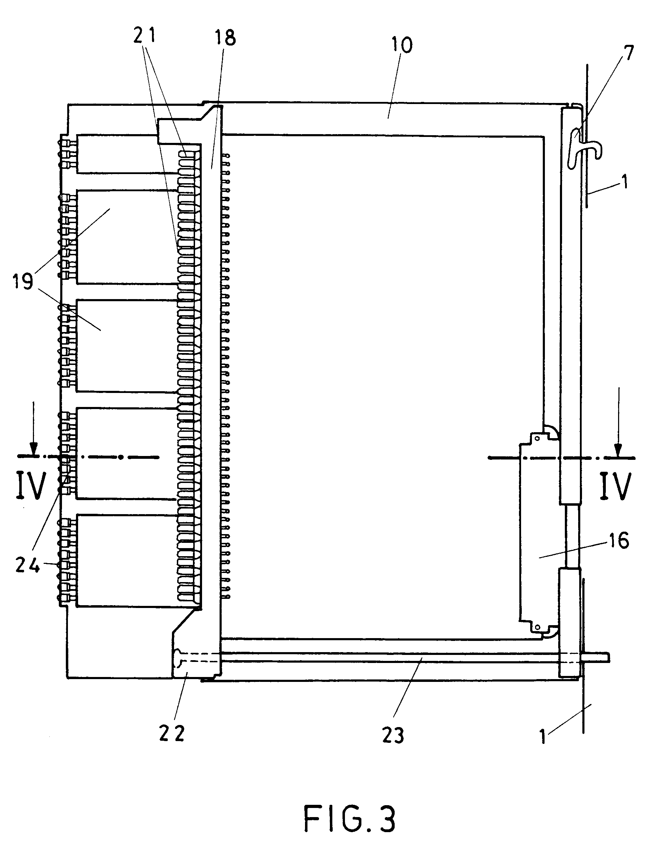

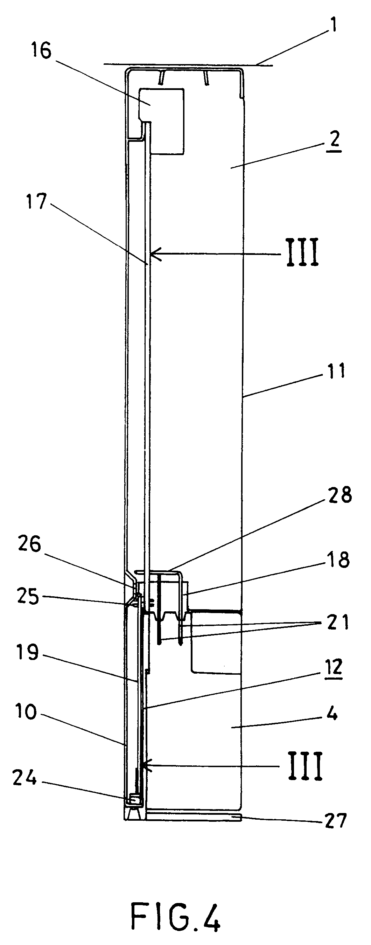

Aus den Figuren 3 und 4 ist die genauere Ausbildung einer Baugruppe 2 ersichtlich. So ist aus Fig.3 (Seitenansicht nach Entfernen der Abdeckungen 11,12) zu erkennen, dass die Steckerleiste 18 Anschlussstifte 21 sowie ein gegebenenfalls auch am Tragteil 10 vorsehbares Lagerelement 22 und eine Spannschraube 23 trägt, und dass ferner mehrere Leiterplatten 19 mit Anzeigedioden 24 vorgesehen sind. Aus Fig.4 (Aufsicht auf einen längs IV-IV geführten Schnitt durch die Baugruppe 2, wobei im Gegensatz zu Fig.3 die Abdeckungen 11 und 12 eingesetzt sind und der Prozessstecker 4 in die Baugruppe 2 eingeschwenkt ist,) ist zu ersehen, dass die Leiterplatte 17 über Kontaktteile 25 mit den Leiterplatten 19 elektrisch und mechanisch verbunden ist, dass die Steckerleiste 18 mittels Schrauben 26 mechanisch fest mit dem Tragteil 10 des Gehäuses der Baugruppe 2 verbunden ist, und dass der eingeschwenkte Prozessstecker 4 von einer Tür 27 abgedeckt ist, die schwenkbar an der am Tragteil 10 eingeschnappten Abdeckung 12 angebracht ist. Ferner ist ersichtlich, dass die Anschlussstifte 21 gekrümmt ausgebildete, elastisch verformbare Anschlussteile 28 enthalten, an denen die Leiterplatte 17 vorzugsweise mittels Einpresstechnik abgestützt ist.

Das erfindungsgemässe Ein- und/oder Ausgabegerät wirkt wie folgt: Zur Inbetriebnahme wird nach Einschwenken und Fixieren der Baugruppe 2 mittels Befestigungskralle 7 und Spannschraube 23 am Baugruppenträger 1 zunächst der Prozessstecker 4 mit einem Lagerelement auf dem Lagerelement 22 der Steckerleiste 18 aufgesetzt und durch eine in der Zeichenebene gemäss Fig.3 erfolgende Drehbewegung in die in Fig.4 dargestellte Position geführt. Hierbei kontaktieren nicht dargestellte und mit den Kabeln 6 elektrisch leitend verbundene Buchsen des Prozesssteckers 4 die Anschlussstifte 21 und stellen somit über die Leiterbahnen und gegebenenfalls vorgesehene Bauelemente der Leiterplatte 17 eine elektrische Wirkverbindung zwischen den Signalgebern und/oder Signalaufnehmern der Vorrichtung zur Durchführung des Prozesses und dem Bus bzw. anderen Baugruppen 2 her.

Da durch die Kabel 6 gegebenenfalls auch mechanische Kräfte übertragen werden, wird der eingeschwenkte Prozessstecker 4 beispielsweise mittels einer von der Tür 27 abgedeckten und auf die Steckerleiste 18 wirkenden Verschraubung gegen unerwünschte Bewegung gesichert. Die von den Kabeln 6 herbeigeführten mechanischen Kräfte werden über den Prozessstecker 4, die Steckerleiste 18 und das Tragteil 10 auf den Baugruppenträger 1 übertragen. Dies ist dadurch bedingt, dass der Prozesstecker 4 über das durch sein Lagerelement und das Lagerelement 22 gebildete Schwenkgelenk und die Schraubverbindung mit der Steckerleiste 18 kraftschlüssig verbunden ist, und dass entsprechend die Steckerleiste 18 mittels der Schrauben 26 kraftschlüssig auf dem Tragteil 10 aufliegt und über dieses, die Befestigungskralle 7 und die Spannschraube 23 mechanisch fest an den Baugruppenträger 1 angekoppelt ist.

Die Leiterplatte 17 bleibt nahezu frei von unerwünschten mechanischen Kräften. Dies ist dadurch bedingt, dass die Leiterplatte 17 zumindest im Bereich der Steckerleiste 18 lediglich über elastisch verformbare Anschlussstifte 21 gehalten ist. Vom Prozessstecker 4 in die Baugruppe 2 geführte mechanische Kräfte beeinflussen daher die Leiterplatte 17 gerade dort kaum, wo hervorgerufen durch die Krafteinleitung die grösste mechanische Beanspruchung auftreten würde.

Sind im Busstecker 16 entsprechend dem Steckerleistenbereich ausgebildete und in die Leiterplatte 17 eingepasste Anschlussstifte vorgesehen, welche mit Buchsen der Buskupplung 9 (Fig.1) zusammenwirken, so ist die Leiterplatte 17 nirgends kraftschlüssig mit den kräfteübertragenden Teilen, wie Prozessstecker 4, Steckerleiste 18, Tragteil 10 und Baugruppenträger 1, verbunden und ist nun in besonders vorteilhafter Weise gegen Beschädigungen geschützt.

## Patentansprüche

1. Ein- und/oder Ausgabegerät für Prozessdaten mit einem Baugruppenträger (1), mindestens einer auf dem Baugruppenträger (1) befestigten Baugruppe (2) und einem an der Frontseite in die mindestens eine Baugruppe (2) einführbaren Prozessstecker (4), bei der die mindestens eine Baugruppe (2) mindestens eine in einem Gehäuse angeordnete und mit dem Prozessstecker (4) sowie einem Busstecker (16) elektrisch leitend verbundene Leiterplatte (17) sowie eine mit dem Prozessstecker (4) kraftschlüssig verbundene Steckerleiste (18) aufweist, dadurch gekennzeichnet, dass die Steckerleiste (18) mechanisch fest mit dem Gehäuse verbunden ist und elastisch verformbare Anschlussstifte (21) enthält, auf welchen die Leiterplatte (17) abgestützt ist.

2. Ein- und/oder Ausgabegerät nach Anspruch 1, dadurch gekennzeichnet, dass der Busstecker (16) mechanisch fest mit dem Gehäuse verbunden ist und elastisch verformbare Anschlussstifte enthält, auf welchen die Leiterplatte (17) abgestützt ist.

3. Ein- und/oder Ausgabegerät nach einem der Ansprüche 1 oder 2,dadurch gekennzeichnet, dass das Gehäuse ein am Baugruppenträger (1) lösbar befestigtes Tragteil (10) und eine auf dem Tragteil (10) abgestützte Abdeckung (11,12) enthält.

4. Ein- und/oder Ausgabegerät nach Anspruch 3, dadurch gekennzeichnet, dass die Steckerleiste (18) und der Busstecker (16) am Tragteil (10) befestigt sind.

5. Ein- und/oder Ausgabegerät nach Anspruch 3, dadurch gekennzeichnet, dass am Tragteil (10) oder an der Steckerleiste (18) ein Lagerelement (22) befestigt ist, in dem ein am Prozessstecker (4) befestigtes Lagerelement schwenkbar geführt ist.

## Claims

1. Input and/or output device for process data comprising a subrack (1), at least one assembly (2) mounted on the subrack (1) and a process connector (4) which can be introduced into the at least one assembly (2) at the front, in which the at least one assembly (2) exhibits at least one circuit board (17) arranged in a housing and electrically conductively connected to the process connector (4) and to a bus connector (16), and a connector strip (18) frictionally connected to the process connector (4), characterized in that the connector strip (18) is mechanically rigidly connected to the housing and contains elastically deformable terminal pins (21) on which the circuit board (17) is supported.

2. Input and/or output device according to Claim 1, characterized in that the bus connector (16) is mechanically rigidly connected to the housing and contains elastically deformable terminal pins on which the circuit board (17) is supported.

3. Input and/or output device according to one of Claims 1 or 2, characterized in that the housing contains a support part (10) detachably attached to the subrack (1) and a cover (11, 12) supported on the support part (10).

4. Input and/or output device according to Claim 3, characterized in that the connector strip (18) and the bus connector (16) are mounted on the support part (10).

5. Input and/or output device according to Claim 3, characterized in that a support element (22) in which a support element mounted on the process connector (4) is pivotably carried is mounted on the support part (10) or on the connector strip (18).

## Revendications

1. Appareil d'entrée/sortie pour données de processus, avec un châssis (1), au moins une unité (2) fixée sur le châssis (1) et un connecteur (4) à introduire à la face avant dans ladite au moins une unité (2), dans lequel ladite au moins une unité (2) présente au moins une plaquette de circuits imprimés (17) disposée dans un boîtier et électriquement reliée au connecteur (4) ainsi qu'à un connecteur de bus (16) ainsi qu'une barrette de connexion (18) raccordée, pour la transmission des efforts, au connecteur (4), caractérisé en ce que la barrette de connexion (18) est solidement assemblée mécaniquement avec le boîtier et comporte des broches de raccordement (21) élastiquement déformables, sur lesquelles la plaquette de circuits imprimés (17) est appuyée.

2. Appareil d'entrée/sortie suivant la revendication 1, caractérisé en ce que le connecteur de bus (16) est solidement assemblé mécaniquement avec le boîtier et comporte des broches de raccordement élastiquement déformables, sur lesquelles la plaquette de circuits imprimés (17) est appuyée.

3. Appareil d'entrée/sortie suivant l'une des revendications 1 ou 2, caractérisé en ce que le boîtier comporte une pièce portante (10) démontable fixée au châssis (1) et un couvercle (11, 12) appuyé sur la pièce portante (10).

4. Appareil d'entrée/sortie suivant la revendication 3, caractérisé en ce que la barrette de connexion (18) et le connecteur de bus (16) sont fixés à la pièce portante (10).

5. Appareil d'entrée/sortie suivant la revendication 3, caractérisé en ce qu'à la pièce portante (10) ou à la barrette de connexion (18) est fixé un élément de support (22), dans lequel est guidé un élément de support basculant fixé au connecteur (4).
